# EUROPÄISCHE PATENTSCHRIFT

(11) **EP 2 816 879 B1**
(45) Veröffentlichungstag und Bekanntmachung des Hinweises auf die Patenterteilung: **29.03.2017**
(21) Anmeldenummer: 14171304.0
(22) Anmeldetag: 05.06.2014
(51) Int. Cl.: H05K 5/02, H02B 1/14, H02G 3/08

(54) **Leitungsanschluss**
Lead connector
Raccordement de ligne

(30) Priorität: 21.06.2013 DE 102013010364
(43) Veröffentlichungstag der Anmeldung: 24.12.2014
(73) Patentinhaber: Wieland Electric GmbH, 96052 Bamberg (DE)
(72) Erfinder: Achtziger, Bernd, 96138 Burgebrachde (DE); Krause, Alexander, 96052 Bamberg (DE)
(74) Vertreter: Tergau, Dietrich

(56) Entgegenhaltungen:
- EP-A1- 0 818 855
- EP-A2- 0 805 522
- US-A- 4 108 527

## Beschreibung

Die vorliegende Erfindung betrifft einen Anschluss für elektrische Leitungen. Insbesondere bei Schaltschränken, elektrischen Geräten oder dergleichen besteht die Notwendigkeit, die im Schaltschrank oder im technischen Gerät befindlichen Komponenten mit der Außenwelt zu verbinden. Zumindest besteht in der Regel die Notwendigkeit, eine elektrische Verbindung zur Energieeinspeisung vorzusehen. Es können aber auch Datenleitungen, Signalleitungen oder weitere Leitungen an den Schaltschrank oder das elektrische Gerät angeschlossen Werden.

Bei derartigen Anschlüssen oder Schnittstellen nach außen besteht die Notwendigkeit, dass der Anschluss insbesondere gegen Feuchtigkeits-, Schmutz-, Staubund Lichteinwirkung geschützt ist. Außerdem besteht die Notwendigkeit, den Anschluss auch gegen mechanische Störeinflüsse, insbesondere gegen auf die Leitung ausgeübte Zugkräfte zu schützen. Ein sehr gut geeignetes Mittel für einen solchen Anschluss für eine elektrische Leitung stellt in der Regel ein elektrischer Steckverbinder dar. Hierbei wird die Leitung in einem Steckverbindergehäuse an Stecker- oder Buchsenkontakte angeschlossen. Diese Kontakte können als Schraubkontakte, Federkontakte, Crimpkontakte oder dergleichen ausgestaltet sein. In der Regel nimmt das Steckverbindergehäuse die Enden der einzelnen Leiter, welche an die Kontakte angeschlossen sind, auf. Zudem ist üblicherweise an der Rückseite des Steckverbindergehäuses eine Zugentlastung vorgesehen, so dass die Leitung vor den vorerwähnten Umwelteinflüssen wirksam abgeschirmt ist. Am Schaltschrank bzw. am elektrischen Gerät sind entsprechende Gegenkontakte ausgebildet, in welche die am Steckverbinder ausgebildeten Kontakte einfach eingeschoben werden können. Zusätzlich zu der so geschaffenen formschlüssigen Steckverbindung können noch zusätzliche mechanische Verriegelungselemente, beispielsweise Verriegelungshaken vorgesehen sein.

Bei großen Leitungsquerschnitten für die Übertragung von hohen Strömen, beispielsweise bis zu 35 Ampere, kann der Einbauraum im Steckverbinder knapp werden. Insbesondere kann sich die Montage vor Ort, nämlich der Anschluss der einzelnen Leiter an die Kontakte des Steckverbinders sehr mühsam gestalten. Bei derartigen Montagekonstellationen ist es deshalb möglich, dass der Fachmann einen primären Anschluss bevorzugt. Ein derartiger primärer Anschluss kann im Inneren des Schaltschranks oder des elektrischen Geräts vorgesehen sein. In der Regel ist eine Frontplatte mit Öffnungen für die den einzelnen Leitern zugeordneten elektrischen Anschlüsse vorgesehen. Die Leiter werden an diese Anschlüsse angeschlossen. Die Leitung ist dabei durch eine Leitungsdurchführung in der Schaltschrank- oder gehäusewand nach außen geführt. Die Leitungsdurchführung kann mit entsprechenden Elementen zur Abdichtung versehen sein. Ebenso ist es möglich, im Bereich der Leitungsdurchführung eine Zugentlastung vorzusehen.

Nachteilig hierbei ist die Notwendigkeit, das Gehäuse beim Anschließen öffnen zu müssen. Gerade bei elektrischen Geräten ist es schon im Hinblick auf mögliche Gewährleistungsansprüche häufig unerwünscht, dass das Gerätegehäuse nachdem Verlassen des Herstellungsbetriebs noch einmal geöffnet wird.

Aus der EP 0 805 522 A2 ist ein Anschluss für eine elektrische Leitung mit einer Frontplatte mit Anschlussöffnungen für elektrische Leiter bekannt. An der Frontplatte ist ein aus zwei Gehäuseelementen bestehendes Gehäuse adaptiert, welches die elektrische Leitung im Montageendzustand aufnimmt und die Frontplatte nach außen abschirmt. Als nachteilig bei diesem Anschluss wird die Tatsache empfunden, dass die elektrische Leitung gegen Zugbelastungen nicht gesondert gesichert ist.

Ausgehend von diesen Überlegungen liegt der Erfindung die Aufgabe zugrunde, einen Primäranschluss für eine elektrische Leitung anzugeben, welcher an der Außenwand eines Schaltschranks oder eines elektrischen Geräts angeordnet werden kann und welcher die für den Betrieb des Schaltschranks oder elektrischen Geräts erwünschten Eigenschaften in Bezug auf äußere Einflüsse aufweist.

Diese Aufgabe ist durch die Merkmalskombination des Anspruchs 1 in erfinderischer Weise geschützt. Die rückbezogenen Ansprüche beinhalten teilweise vorteilhafte und teilweise für sich selbst erfinderische Weiterbildungen dieser Erfindung.

Der erfindungsmäßige Anschluss für eine elektrische Leitung beruht auf der Grundüberlegung, eine an sich bekannte Frontplatte mit Öffnungen für die den einzelnen Leitern der Leitung zugeordneten elektrischen Anschlüsse direkt an der Schaltschrank- oder Gehäuseaußenwand zu positionieren. Auf diese Weise können die Leiter einfach über die in der Frontplatte vorgesehen Öffnungen an den elektrischen Anschlüssen angeschlossen werden. Nach dem Anschließen wird diesem an sich bekannten Anschluss ein Schutzgehäuse gleichsam vorgeschaltet. Das Schutzgehäuse ist aus mehreren Gehäuseelementen zusammengesetzt. Zur Fixierung des Schutzgehäuses ist an der Frontplatte eine Befestigungsvorrichtung vorgesehen. Die Gehäuseelemente sind dabei so ausgestaltet, dass sie im Montageendzustand an der Befestigungsvorrichtung ein die elektrische Leitung aufnehmendes und die Frontplatte nach außen abschirmendes Schutzgehäuse bilden.

Zur funktionellen Vollendung des Schutzgehäuses ist an der Schutzgehäuserückwand ein Leitungsdurchlass vorgesehen. Dieser Leitungsdurchlass ist mit einer Zugentlastung kombiniert. Die mit der Erfindung realisierte Ausgestaltung einer solchen Zugentlastung besteht in der Einbringung eines L-förmigen Federhebels. Dieser Federhebel ist im Zwickel zwischen seinen beiden L-Schenkeln, also an seiner Innenseite mit einer ausgerundeten Innenkontur versehen, welche an die Außenkontur der elektrischen Leitung angepasst ist. Mit dieser Innenkontur liegt der Federhebel am Außenmantel der elektrischen Leitung im Montageendzustand an. Der längere L-Schenkel, also der Langschenkel ist federnd ausgebildet und dient als Adaptierung des Federhebels an dem entsprechenden Gehäuseelement. Der Kurzschenkel weist an seiner Außenseite eine Verzahnung auf, welche im Montageendzustand in eine Gegenverzahnung am zugeordneten anderen Gehäuseelement eingreift. Zum Schließen der Zugentlastung wird der Federhebel einfach in Richtung auf die elektrische Leitung verdrückt. Die Verzahnung am Kurzschenkel übergleitet dabei die Gegenverzahnung und sichert so die Lage des Federhebels in seiner jeweiligen Montageposition. Mit anderen Worten dient der durch die Verzahnung und die Gegenverzahnung realisierte Ratschenmechanismus zum Öffnen und Schließen der Zugentlastung. Der L-förmige Federhebel ist hierbei als Sperrklinke wirksam. Die Verzahnung und die Gegenverzahnung bilden ein Zahnrichtgesperre für die Sperrklinke miteinander aus.

Zur Adaptierung des Schutzgehäuses ist vorzugsweise eine aus der Ebene der Frontplatte vorspringende Führungsschiene vorgesehen. Auf diese Führungsschiene sind mehrere Gehäuseelemente aufschiebbar, um das Schutzgehäuse im Montageendzustand zu bilden. Montagetechnisch vorteilhaft ist die Verwendung eines aus zwei Gehäuseelementen zusammengesetzten zweiteiligen Schutzgehäuses.

In vorteilhafter Ausgestaltung weisen die Gehäuseelemente Teilflächen auf, die im Montageendzustand des Schutzgehäuses eine obere und untere Seitenwand bilden. Hierbei handelt es sich vorteilhaft um eine ebene durchgehende obere und untere Seitenwand. Zur Koppelung der Gehäuseelemente aneinander sind im Bereich der Stoßkanten der Teilflächen Befestigungselemente ausgebildet. Diese Befestigungselemente dienen im Montageendzustand zur sicheren und dauerhaften Fixierung der Gehäuseelemente aneinander.

Besonders vorteilhaft ist es, von den Stoßkanten abstehende fingerartige Vorsprünge mit komplementär zu diesen Vorsprüngen ausgebildeten Ausnehmungen zu kombinieren. Auf diese Weise ist es möglich, im Montageendzustand ebene obere und untere Seitenwände zu schaffen, weil die Vorsprünge im Montageendzustand in die Ausnehmungen eintauchen und so nicht mehr störend aus der Ebene der entsprechenden Seitenwand vorstehen. Darüber hinaus ist es mit dieser Art von Verriegelungselementen sehr leicht möglich, insbesondere zwei Gehäuseelemente formschlüssig miteinander zu verrasten. Die Verrastung gewährleistet die gewollte Anordnung der Gehäuseelemente im Montageendzustand zueinander. Auf diese Weise kann einfach kontrolliert und gewährleistet werden, dass die Gehäuseelemente in der Montageendstellung auch tatsächlich ihre Sollposition erreicht haben, so dass das Schutzgehäuse auch all seine Wirkungen in Bezug auf Dichtigkeit und Abschirmung gegenüber der Außenwelt entfalten kann.

Fertigungstechnisch günstig ist die Verwendung zweier identischer Gehäusehälften als Gehäuseelemente. Die Gehäusehälften werden spiegelverkehrt zueinander angeordnet, um das Schutzgehäuse zu bilden. Sofern die Gehäusehälften aus Kunststoff gespritzt werden, ist nur eine einzige Spritzform zur Fertigung beider Gehäuseelemente nötig.

Weiterhin vorteilhaft ist die Ausgestaltung der langen Seiten der Frontplatte als Schwalbenschwanzführung. Die langen Seiten der Frontplatte bilden so eine doppelte Führungsschiene für das Schutzgehäuse und gewährleisten so einen sehr betriebssicheren Sitz des Schutzgehäuses an der Frontplatte.

In vorteilhafter Ausgestaltung ist die Frontplatte Bestandteil eines sogenannten Snap-in-Teils. Ein solcher Snap-in-Anschluss wird bei Schaltschränken und Gehäusen häufig verwendet, weil das Teil so einfach in einem Wandausschnitt verschnappt werden kann.

Die als Primärkontakte wirksamen Anschlusskontakte an der Frontplatte sind vorzugsweise als Push-In-Kontakte ausgestaltet. All diese bevorzugten Ausgestaltungen ermöglichen eine werkzeuglose Montage des erfindungsmäßigen Anschlusses.

Der erfindungsmäßige Anschluss eignet sich zum Anschluss aller gängigen Leitungstypen, insbesondere zum Anschluss von NYM-Leitungen. Da das Schutzgehäuse des erfindungsmäßigen Anschluss auch größer ausfallen kann, eignet sich das System auch zum Anschluss großer Leitungsquerschnitte, welche erforderlich sind, um Ströme bis hin zu 50 Ampere zu übertragen.

Anhand eines Ausführungsbeispiels ist die Erfindung mit weiteren Vorteilen beschrieben. Es zeigen:
- Fig. 1: eine Explosionsdarstellung eines erfindungsmäßigen Anschlusses mit einer Frontplatte, einer Gehäusehälfte sowie einen abisolierten Leiter einer Leitung sowie
- Fig. 2: eine Draufsicht auf den Anschlussblock mit der Frontplatte,
- Fig. 3: eine Schnittdarstellung der noch nicht montierten Rückwand eines Schutzgehäuses mit eingebrachten Federhebeln zur Realisierung einer Zugentlastung

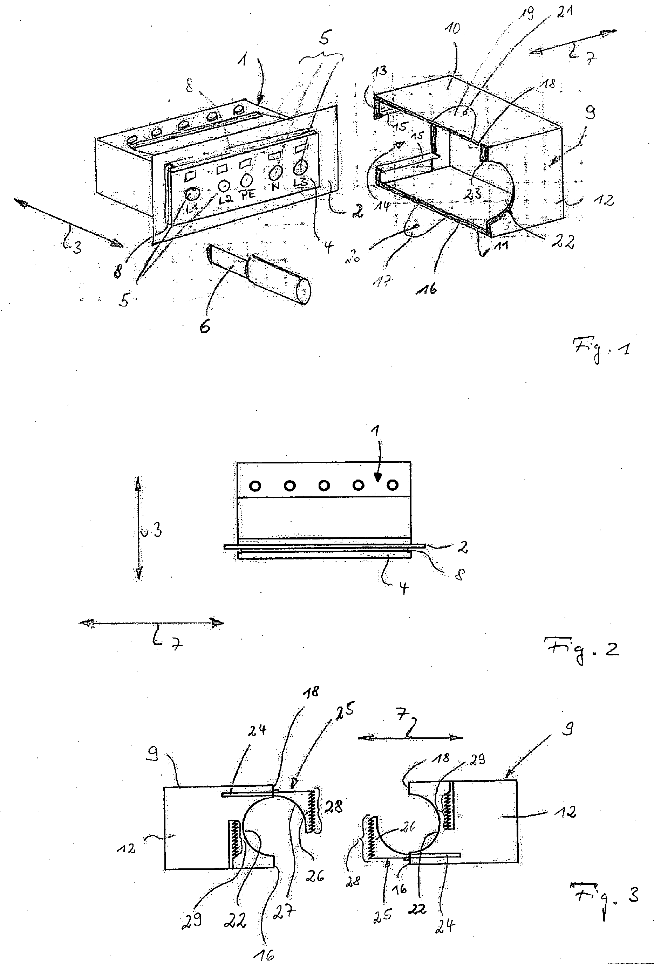

In Fig. 1 erkennbar ist ein als Snap-in-Anschluss ausgebildeter Anschlussblock 1. Dieser Anschlussblock 1 weist an seiner Vorderseite eine Frontplatte 2 auf. Aus der Frontplatte 2 steht in Längsrichtung 3 ein Schwalbenschwanz 4 hinaus. Der Schwalbenschwanz 4 ist von Öffnungen 5 durchsetzt. Durch die Öffnungen 5 werden Leiter 6 in den Anschlussblock 1 eingeführt und mit in Längsrichtung 3 hinter der Frontplatte 2 angeordneten Push-in-Kontakten verbunden. Zwischen dem Schwalbenschwanz 4 und der Frontplatte 2 verlaufen in der zur Längsrichtung 3 rechtwinklig verlaufenden Querrichtung 7 sowohl hinter dem oberen als auch hinter dem unteren Rand des Schwalbenschwanzes 4 Führungsnuten 8 als Bestandteil einer Schwalbenschwanzführung. Der Schwalbenschwanz 4 mit seinen Führungsnuten 8 wirkt so als doppelte aus der Ebene der Frontplatte 2 abstehende Führungsschiene.

In Fig. 1 ist weiterhin ein Gehäuseelement 9 dargestellt. Das Gehäuseelement 9 weist eine obere Teilfläche 10 und eine untere Teilfläche 11 sowie eine Rückwand 12 auf. Die der Rückwand 12 in Längsrichtung 3 gegenüberliegende Vorderwand 13 weist einen Durchbruch 14 auf. An den Rändern des Durchbruchs 14 sind Führungsleisten 15 angeordnet. Die Führungsleisten 15 sind komplementär zu den Führungsnuten 8 ausgestaltet. Die Führungsleisten 15 werden zur Montage des Gehäuseelements 9 am Anschlussblock 1 in die Führungsnuten 8 in Querrichtung 7 eingeschoben. Im Montageendzustand füllt der Schwalbenschwanz 4 den Durchbruch 14 aus. Der Übersichtlichkeit halber ist in Fig. 1 das zweite Gehäuseelement 9 nicht dargestellt, welches von der linken Seite her auf den Schwalbenschwanz 4 aufgeschoben wird. Fig. 1 zeigt eine Ausführungsform der Gehäuseelemente 9, bei der die Gehäuseelemente 9 als identische Gehäusehälften ausgestaltet sind.

Beispielhaft angedeutet in Fig. 1 ist ein aus der unteren Stoßkante 16 des Gehäuseelements 9 in Querrichtung 7 abstehender fingerartiger Vorsprung 17. Ebenso ist im Bereich der oberen Stoßkante 18 eine in die obere Teilfläche 10 eingebrachte Ausnehmung 19 gezeigt. Der fingerartige Vorsprung 17 und die Ausnehmung 19 sind in ihrer Form komplementär zueinander ausgebildet. Der fingerartige Vorsprung 17 trägt einen Rastnocken 20. Im Montageendzustand greift dieser Rastnocken 20 rastend in eine Rastbohrung 21 in der Ausnehmung 19 ein. Die beiden als identische Gehäusehälften ausgebildeten Gehäuseelemente 9 sind dabei spiegelverkehrt zueinander auf den Schwalbenschwanz 4 aufgeschoben, so dass bei dem in Fig. 1 nicht dargestellten linken Gehäuseelement 9 der Vorsprung 17 aus der oberen Teilfläche 10 vorspringen würde, so dass dementsprechend die untere Teilfläche 11 des linken Gehäuseelements 9 mit einer Ausnehmung 19 versehen wäre, in welche dementsprechend der Vorsprung 17 des rechts tatsächlich dargestellten Gehäuseelements 9 eingreifen könnte. Im Montageendzustand bilden die oberen Teilflächen 10 der Gehäuseelemente 9 die obere Seitenwand des Schutzgehäuses. Dementsprechend bilden die unteren Teilflächen 11 der beiden Gehäuseelemente 9 die untere Seitenwand des Schutzgehäuses.

Die Rückwand 12 des Gehäuseelements 9 weist einen als Leitungsdurchlass 22 wirksamen Durchbruch auf. Bei dem in Fig. 1 dargestellten Gehäuseelement 9 ist der Leitungsdurchlass 22 halbkreisförmig. Wird das Gehäuseelement 9 durch ein weiteres identisches und spiegelverkehrt montiertes Gehäuseelement 9 ergänzt, ergibt dies einen kreisrunden Leitungsdurchlass 22 für die Leitung mit den Leitern 6.

Angrenzend an die obere Stoßkante 18 der oberen Teilfläche 10 ist in die Rückwand 12 eine Aufnahmetasche 23 zur Aufnahme des Langschenkels 24 eines L-förmigen Federhebels 25 eingebracht. Der Federhebel 25 weist im Bereich seiner Innenseite im Zwickel zwischen dem Langschenkel 24 und dem Kurzschenkel 26 eine ausgerundete Innenkontur 27 auf. An der der Innenkontur 27 abgewandten Außenseite trägt der Kurzschenkel 26 eine Verzahnung 28.

Der Federhebel 25 dient im Montageendzustand als Sperrklinke einer Zugentlastung. Zur Realisierung der Zugentlastung ist in die Aufnahmetasche 23 beider Gehäuseelemente 9 ein Federhebel 25 eingeschoben. Die Gehäuseelemente 9 sind als identische Gehäusehälften ausgestaltet und werden spiegelbildlich zueinander montiert, was in Fig. 3 dargestellt ist. Werden die in Fig. 3 dargestellten Gehäuseelemente 9 in Querrichtung 7 so aneinander geschoben, dass die Stoßkanten 16, 18 aneinander liegen, greifen die Verzahnungen 28 an den beiden Federhebeln 25 in Gegenverzahnungen 29 ein, welche an den Gehäuseelementen 9 ausgebildet sind. Im Montageendzustand durchsetzt die Leitung mit den Leitern 6 den Leitungsdurchlass 22 an der Rückwand 12 des aus den beiden Gehäuseelementen 9 zusammengesetzten Schutzgehäuses. Dabei flankieren die beiden Federhebel 25 mit ihren Innenkonturen 27 den Mantel der elektrischen Leitung. Werden die beiden Kurzschenkel 26 in Richtung auf das Innere des Leitungsdurchlasses 22 verdrückt, gleiten die Verzahnungen 28 auf den Gegenverzahnungen 29 entlang und der Langschenkel 24 federt ein. Die so aufeinander zubewegten Kurzschenkel 26 verkleinern den Durchmesser des Durchlasses 22 und klemmen so die Leitung mit den Leitern 6 zur Bildung einer Zugentlastung zwischen sich. Die Gegenverzahnungen 29 halten die Verzahnungen 28 und somit den als Sperrklinke wirksamen Federhebel 25 in seiner jeweiligen Sperrstellung. In der Sperrstellung sind die Federhebel 25 als Zugentlastung wirksam.

### Bezugszeichenliste

- 1: Anschlussblock
- 2: Frontplatte
- 3: Längsrichtung
- 4: Schwalbenschwanz
- 5: Öffnung
- 6: Leiter
- 7: Querrichtung
- 8: Führungsnut
- 9: Gehäuseelement
- 10: obere Teilfläche
- 11: untere Teilfläche
- 12: Rückwand
- 13: Vorderwand
- 14: Durchbruch
- 15: Führungsleiste
- 16: untere Stoßkante
- 17: Vorsprung
- 18: obere Stoßkante
- 19: Ausnehmung
- 20: Rastnocke
- 21: Rastbohrung
- 22: Leitungsdurchlass
- 23: Aufnahmetasche
- 24: Langschenkel
- 25: Federhebel
- 26: Kurzschenkel
- 27: Innenkontur
- 28: Verzahnung
- 29: Gegenverzahnung

## Patentansprüche

1. Anschluss für eine elektrische Leitung mit einer Frontplatte (2) mit Öffnungen (5) für die den einzelnen Leitern (6) der Leitung zugeordneten elektrischen Anschlüsse mit mindestens einer Befestigungsvorrichtung an der Frontplatte (2) und mit mindestens zwei an der Befestigungsvorrichtung adaptierten Gehäuseelementen (9) derart, dass das oder die Gehäuseelemente (9) im Montageendzustand ein die elektrische Leitung aufnehmendes und die Frontplatte (2) nach außen abschirmendes Schutzgehäuse bilden,
**gekennzeichnet durch**
eine von einem Leitungsdurchlass (22) durchbrochene Rückwand (12) an der der Frontplatte (2) gegenüberliegenden Seite des Schutzgehäuses mit einer Zugentlastung am Leitungsdurchlass (22) und **durch** einen L-förmigen Federhebel (25), welcher mit seinem Langschenkel (24) an einem Gehäuseelement (9) fixiert ist, welcher an seiner Innenseite eine der Außenkontur der Leitung angepasste Innenkontur (27) aufweist und welcher an der Außenseite seines Kurzschenkels (26) eine Verzahnung (28) trägt, welche im Montageendzustand in eine am benachbarten Gehäuseelement (9) ausgebildete Gegenverzahnung (29) eingreift zur Bildung des Zahnrichtgesperres als Verschluss der Zugentlastung.

2. Anschluss nach Anspruch 1
**gekennzeichnet durch**
mindestens eine Führungsschiene als Befestigungsvorrichtung und auf die Führungsschiene aufschiebbare Gehäuseelemente (9).

3. Anschluss nach Anspruch 1 oder 2
**dadurch gekennzeichnet,**
**dass** die Gehäuseelemente (9) Teilflächen (10, 11) aufweisen, die im Montageendzustand des Schutzgehäuses eine obere und eine untere Seitenwand bilden, wobei im Bereich der Stoßkanten (16, 18) der Teilflächen (10, 11) Befestigungselemente ausgebildet sind zur Fixierung der Gehäuseelemente (9) aneinander.

4. Anschluss nach Anspruch 3
**gekennzeichnet durch**,
von den Stoßkanten (16, 18) abstehende fingerartige Vorsprünge (17) und **durch** zu den Vorsprüngen (17) komplementär ausgebildete Ausnehmungen (19) derart, dass im Montageendzustand des Schutzgehäuses ein Vorsprung (17) des einen Gehäuseelements (9) in eine zugehörige Ausnehmung (19) des jeweils benachbarten Gehäuseelements (9) eingreift.

5. Anschluss nach einem der Ansprüche 1 bis 4
**gekennzeichnet durch**
zwei identische und spiegelverkehrt zueinander montierte Gehäusehälften als Gehäuseelemente (9).

6. Anschluss nach einem der Ansprüche 1 bis 5
**dadurch gekennzeichnet,**
**dass** aus der Ebene der Frontplatte 2 eine Schwalbenschwanzführung absteht, deren Langseiten eine doppelte Führungsschiene für die Gehäuseelemente (9) bilden.

7. Anschluss nach einem der Ansprüche 1 bis 6
**dadurch gekennzeichnet,**
**dass** die Frontplatte (2) Bestandteil eines in eine Außenwand eines elektrischen Geräts oder Schaltschranks einsetzbaren Einschnappteils ist.

8. Anschluss nach einem der Ansprüche 1 bis 7
**gekennzeichnet durch**
Push-in-Kontakte als elektrische Anschlüsse.

## Claims

1. Connector for an electrical lead, comprising a front plate (2) having apertures (5) for the electrical terminals associated with the individual conductors (6) of the lead, comprising at least one fastening apparatus on the front plate (2), and comprising at least two housing elements (9) adjusted on the fastening apparatus such that, in the final assembled state, the one or more housing elements (9) form a protective housing that receives the electrical lead and shields the front plate (2) from outside,
**characterised by**
a rear wall (12) on the side of the protective housing that is opposite the front plate (2), through which rear wall a lead opening (22) passes and which has a strain relief on the lead opening (22), and by an L-shaped spring lever (25), which is attached to a housing element (9) by the long leg (24) thereof, has, on the inner face thereof, an inner contour (27) that is adapted to the outer contour of the lead, and has, on the outer face of the short leg (26) thereof, a toothing (28) that, in the final assembled state, engages in a counter toothing (29) formed on an adjacent housing element (9) in order to form the toothed directional locking means as a catch for the strain relief.

2. Connector according to claim 1,
**characterised by**
at least one guide rail as the fastening apparatus, and housing elements (9) which can be slid onto the guide rail.

3. Connector according to either claim 1 or claim 2,
**characterised in that**
the housing elements (9) comprise surfaces (10, 11) that form an upper side wall and a lower side wall in the final assembled state of the protective housing, fastening elements being formed in the region of the abutting edges (16, 18) of the surfaces (10, 11) for attaching the housing elements (9) to one another.

4. Connector according to claim 3,
**characterised by**
finger-like projections (17) that protrude from the abutting edges (16, 18), and by recesses (19) formed so as to be complementary to the projections (17), such that a projection (17) of one housing element (9) engages in an associated recess (19) in the other adjacent housing element (9) in the final assembled state of the protective housing.

5. Connector according to any of claims 1 to 4,
**characterised by**
two housing halves as the housing elements (9), which halves are identical and assembled so as to be mirror-inverted in relation to one another.

6. Connector according to any of claims 1 to 5,
**characterised in that**
a dovetail guide protrudes from the plane of the front plate 2, the long sides of which guide form a dual guide rail for the housing elements (9).

7. Connector according to any of claims 1 to 6,
**characterised in that**
the front plate (2) is a component of a snap-in part that can be inserted into an outer wall of an electrical device or switch cabinet.

8. Connector according to any of claims 1 to 7,
**characterised by**
push-in contacts as the electrical terminals.

## Revendications

1. Raccordement pour une ligne électrique, avec une plaque frontale (2) munie d'ouvertures (5) pour les bornes électriques affectés aux différents conducteurs (6) de la ligne, avec au moins un dispositif de fixation sur la plaque frontale (2), et avec au moins deux éléments de boîtier (9) adaptés sur le dispositif de fixation de telle sorte que, dans l'état monté fini, l'élément ou les éléments de boîtier (9) forment un boîtier de protection logeant la ligne électrique et blindant la plaque frontale (2) vers l'extérieur,
**caractérisé par**
une paroi arrière (12), percée d'un passage de ligne (22), sur le côté du boîtier de protection opposé à la plaque frontale (2), avec une décharge de traction sur le passage de ligne (22), et par un levier à ressort (25) en forme de L, qui est fixé par sa grande branche (24) sur un élément de boîtier (9), qui présente sur son côté intérieur un contour intérieur (27) adapté au contour extérieur de la ligne et qui, sur le côté extérieur de sa petite branche (26), présente une denture (28) qui, dans l'état monté fini, engrène dans une contre-denture (29) constituée sur l'élément de boîtier (9) voisin pour la formation du dispositif d'encliquetage directionnel denté en tant que verrouillage de la décharge de traction.

2. Raccordement selon la revendication 1,
**caractérisé par**
au moins un rail de guidage en tant que dispositif de fixation et des éléments de boîtier (9) pouvant être glissés sur le rail de guidage.

3. Raccordement selon la revendication 1 ou 2,
**caractérisé en ce que**
les éléments de boîtier (9) présentent des surfaces partielles (10, 11) qui, dans l'état monté fini du boîtier de protection, forment une paroi latérale supérieure et une paroi latérale inférieure, des éléments de fixation étant constitués dans la zone des arêtes de joint (16, 18) des surfaces partielles (10, 11) pour la fixation des éléments de boîtier (9) les uns aux autres.

4. Raccordement selon la revendication 3,
**caractérisé par**
des saillies (17) en forme de doigt qui s'éloignent des arêtes de joint (16, 18), et par des creux (19) constitués de façon complémentaire aux saillies (17) de telle sorte que, dans l'état monté fini du boîtier de protection, une saillie (17) d'un élément de boîtier (9) engrène dans un creux (19) correspondant de l'élément de boîtier (9) respectivement voisin.

5. Raccordement selon l'une des revendications 1 à 4,
**caractérisé par**
deux moitiés de boîtier, identiques et montées en symétrie inverse l'une par rapport à l'autre, en tant qu'éléments de boîtier (9).

6. Raccordement selon l'une des revendications 1 à 5,
**caractérisé en ce**
**qu'**un guidage en queue d'aronde s'éloigne du plan de la plaque frontale 2, guidage dont les grands côtés forment un rail de guidage double pour les éléments de boîtier (9).

7. Raccordement selon l'une des revendications 1 à 6,
**caractérisé en ce que**
la plaque frontale (2) fait partie intégrante d'une partie d'enclenchement pouvant être introduite dans une paroi extérieure d'un appareil électrique ou d'une armoire électrique.

8. Raccordement selon l'une des revendications 1 à 7,
**caractérisé par**
des contacts push-in en tant que bornes électriques.
